# EUROPÄISCHE PATENTSCHRIFT

(11) **EP 3 059 862 B1**
(45) Veröffentlichungstag und Bekanntmachung des Hinweises auf die Patenterteilung: **30.12.2020**
(21) Anmeldenummer: 16156555.1
(22) Anmeldetag: 19.02.2016
(51) Int. Cl.: H03K 17/96

(54) **BEDIENEINRICHTUNG FÜR EIN ELEKTROKOCHGERÄT UND ELEKTROKOCHGERÄT**
OPERATING DEVICE FOR AN ELECTRIC COOKING DEVICE AND ELECTRIC COOKING DEVICES
DISPOSITIF DE COMMANDE D'APPAREIL ÉLECTRIQUE ET APPAREIL ÉLECTRIQUE

(30) Priorität: 23.02.2015 DE 102015203209
(43) Veröffentlichungstag der Anmeldung: 24.08.2016
(73) Patentinhaber: E.G.O. Elektro-Gerätebau GmbH, 75038 Oberderdingen (DE)
(72) Erfinder: Fiedler, Dr. Mathias, 71263 Merklingen (DE)
(74) Vertreter: Patentanwälte Ruff, Wilhelm, Beier, Dauster & Partner mbB

(56) Entgegenhaltungen:
- EP-A1- 2 355 356
- WO-A1-2004/040762
- DE-A1-102012 010 321
- DE-A1-102013 213 034
- JP-A- 2005 276 528

## Beschreibung

### Anwendungsgebiet und Stand der Technik

Die Erfindung betrifft eine Bedieneinrichtung sowie ein Elektrokochgerät mit einer solchen Bedieneinrichtung.

Aus der DE 102009036162 A1 ist eine Sensorelementeinrichtung für einen kapazitiven Berührungsschalter bekannt, welche eine Leuchtanzeige mit Leuchtmittel aufweist. Ein rahmenartiger Körper aus Kunststoff sitzt auf einem Ringkörper aus elastischem, elektrisch leitfähigem Kunststoff, wobei beide über eine LED als Leuchtmittel gesteckt sind. Hierbei besteht der Nachteil, dass eine Befestigung nicht punktgenau möglich ist, weil vor allem die Anbringung des elastischen Kunststoffs in Form eines Schaumgummis positionsgenau auf einer Leiterplatte nicht leicht ist.

Aus der DE 102012010321 A1 ist eine weitere Bedieneinrichtung mit einer Sensorelementeinrichtung mit einem kapazitiven Berührungsschalter bekannt.

Aus der DE 102013213034 A1 ist eine nochmals weitere Bedieneinrichtung mit einer Sensorelementeinrichtung mit einem kapazitiven Berührungsschalter bekannt, die ähnlich wie die zuvor genannte DE 102012010321 A1 ausgebildet ist. Hier erfolgt eine elektrische Kontaktierung durch ein elektrisch leitfähiges Bedienelementgehäuse der Sensorelementeinrichtung. An seiner Oberseite kontaktiert es ein kapazitives Sensorelement. Eine elektrische Kontaktierung nach unten erfolgt dadurch, dass Haltefüße aus elektrisch leitfähigem Material des Bedienelementgehäuses in Öffnungen in einer Leiterplatte eingesteckt sind. Dabei kann ein auf der Oberseite der Leiterplatte angeordnetes Kontaktfeld elektrisch kontaktiert werden. Zusätzlich ist die Innenwandung der Öffnungen mit Kupfer überzogen und der Passsitz der eingesteckten Haltefüße stellt die elektrische Kontaktierung her. Die Haltefüße für das Bedienelementgehäuse sollen stabil sein, um ihre Befestigungsfunktion erfüllen zu können.

Aus der WO 2004/040762 A1 geht eine weitere Bedieneinrichtung mit einer Sensorelementeinrichtung mit einem kapazitiven Berührungsschalter hervor. Hier ist ein elastischer elektrisch leitfähiger Kunststoffkörper vorgesehen, der mit seiner Oberseite gegen die Unterseite einer Abdeckplatte anliegt. An seiner Unterseite steht ein Steckabschnitt hervor, der hinterschnitten ist und der in eine Öffnung auf einer Leiterplatte eingesteckt werden kann. Durch abstehende Widerhaken kann er nicht so leicht wieder abgezogen werden. Hier kann auch eine elektrische Verbindung an den Kunststoffkörper über die Leiterplatte erfolgen.

Aus der EP 2 355 356 A1 geht eine weitere Bedieneinrichtung hervor mit einer Sensorelementeinrichtung mit einem kapazitiven Berührungsschalter, die einen elektrisch leitfähigen und lichtdurchlässigen Kunststoffkörper aufweist. In einer Ausgestaltung kann er an seiner Unterseite abstehende Rastvorsprünge aufweisen, die in Öffnungen einer Leiterplatte eingesteckt sind. Direkt daneben liegt der Kunststoffkörper zur elektrischen Kontaktierung an Kontaktfeldern auf der Oberseite einer Leiterplatte an.

Aus der JP 2005276528 A ist eine Möglichkeit bekannt, wie eine bessere elektrische Verbindung eines THT-Bauteils an eine Leiterbahn auf einer Leiterplatte erreicht werden kann. Eine Einsteckspitze eines Anschlussbeins ist verjüngt ausgebildet und in einem in eine Bohrung in der Leiterplatte einzusteckenden Bereich mit elektrisch leitfähigem Gummi umgeben. Beim Einstecken des Anschlussbeins bzw. der Spitze wird der elektrisch leitfähige Gummi von oben gegen die Leiterbahn gedrückt. Ein Teil des Gummis wird in die Öffnung eingedrückt.

### Aufgabe und Lösung

Der Erfindung liegt die Aufgabe zugrunde, eine eingangs genannte Bedieneinrichtung sowie ein Elektrokochgerät zu schaffen, mit denen Probleme des Standes der Technik vermieden werden können, und es insbesondere möglich ist, eine praxistaugliche Ausführung zu schaffen, die auch großserientechnisch präzise und zu günstigen Kosten herstellbar ist sowie möglichst auch automatisiert montiert werden kann.

Gelöst wird diese Aufgabe durch eine Bedieneinrichtung mit den Merkmalen des Anspruchs 1 sowie ein Elektrokochgerät mit den Merkmalen des Anspruchs 12. Vorteilhafte sowie bevorzugte Ausgestaltungen der Erfindung sind Gegenstand der weiteren Ansprüche und werden im Folgenden näher erläutert. Dabei werden manche der genannten Merkmale nur für die Bedieneinrichtung oder nur für das Elektrokochgerät genannt. Sie sollen jedoch unabhängig davon sowohl für die Bedieneinrichtung als auch für das Elektrokochgerät selbstständig gelten können.

Es ist vorgesehen, dass die Sensorelementeinrichtung eine Oberseite aufweist, die zur Unterseite eines Bedienfeldes oder einer Bedienblende der Bedieneinrichtung, die eine Bedienfläche bilden, hin weist. Eventuell kann sie sogar daran angelegt sein. Des Weiteren kann die Sensorelementeinrichtung eine Leuchtanzeige mit einem Leuchtmittel aufweisen, wobei eine Leuchtrichtung zur Unterseite der Bedienblende hin weisen kann, möglichst zu dessen Durchstrahlung.

Des Weiteren ist vorgesehen, dass ein Gehäuse vorgesehen ist bzw. die Sensorelementeinrichtung ein Gehäuse aufweist. Zur Befestigung der Sensorelementeinrichtung an einem Bauteilträger kann das Gehäuse Befestigungsmittel aufweisen, wobei die beiden zusammen eine Baueinheit bilden können. Unter Umständen können sie sogar einstückig als Baueinheit ausgebildet sein, was nachfolgend näher erläutert wird. Außen an dem Gehäuse bzw. der Baueinheit ist zumindest in dem Bereich zur Oberseite hin ein elektrisch leitfähiger Kunststoff vorgesehen, mit einem Verlauf zumindest teilweise entlang eines Außenrandes des Gehäuses bzw. der Baueinheit. Dieser elektrisch leitfähige Kunststoff bildet das funktionale kapazitive Sensorelement für den kapazitiven Berührungsschalter an dem Bedienfeld bzw. der Bedienfläche, durch welches das Annähern oder Auflegen eines Fingers auf die Oberseite des Bedienfeldes oberhalb der Sensorelementeinrichtung bzw. des kapazitiven Sensorelements auf bekannte Art und Weise erkannt und ausgewertet werden kann, siehe beispielsweise die DE 102012010321 A1. Von dem elektrisch leitfähigen Kunststoff an der Oberseite in Richtung zur Unterseite auf den Bauteilträger zu ist eine elektrisch leitfähige Verbindung als Kontaktierung vorgesehen bzw. erstreckt sich an den Bauteilträger und an eine Ansteuerung und/oder Auswertung. Diese elektrische Verbindung bzw. Kontaktierung bzw. ein Anschluss an das kapazitive Sensorelement kann verschiedenartig ausgebildet sein, wie nachfolgend noch näher erläutert wird.

Das Gehäuse weist an seinem unteren Bereich oder an seiner Unterseite elektrisch leitfähiges und elastisches Kontaktierungsmaterial auf, das vorzugsweise über die Unterseite des Gehäuses überstehen kann zur Anlage auf dem flächigen Bauteilträger, der vorteilhaft eine Leiterplatte oder Platine ist. Der flächige Bauteilträger weist im Bereich dieses Kontaktierungsmaterials am Gehäuse oder direkt unterhalb davon ein Kontaktfeld auf, das insbesondere unlösbar auf den flächigen Bauteilträger aufgebracht ist. Dieses Kontaktfeld besteht aus elektrisch leitfähigem Material, vorteilhaft Kupfer, und weist eine elektrische Verbindung an ein weiteres Bauteil auf dem Bauteilträger auf, insbesondere einen Microcontroller odgl. als Steuerung oder ggf. eine Vorschaltung mit passiven Bauteilen.

Der Bauteilträger weist an dem Kontaktfeld dort, wo das Kontaktierungsmaterial an dem Kontaktfeld anliegt, eine Ausnehmung auf. Die Ausnehmung im Kontaktfeld ist mit dem Leitermaterial bedeckt, wobei das Leitermaterial in die Ausnehmung hinein verläuft entsprechend der Form der Ausnehmung, vorteilhaft als Beschichtung, und demzufolge dieselbe Kontur aufweist bzw. vorzugsweise die Oberfläche der Ausnehmung bedeckt.

Mit der Erfindung kann somit eine Bedieneinrichtung geschaffen werden, welche einerseits ein Gehäuse aufweist, das ein Leuchtmittel für eine Leuchtanzeige umgeben kann. An seiner Oberseite hin weist es ein Sensorelement auf für den kapazitiven Berührungsschalter, der zu der Baueinheit gehört. Des Weiteren kann das Gehäuse die Befestigungsmittel aufweisen, um vorzugsweise werkzeuglos an einem Bauteilträger befestigt zu werden. Dabei soll gleichzeitig eine elektrische Kontaktierung als elektrischer Anschluss des kapazitiven Sensorelements erfolgen. So ist eben die zuvor genannte schnelle und möglichst automatisierte Montage möglich, was vor allem bei Bedieneinrichtungen mit einer Vielzahl von solchen Sensorelementeinrichtungen von großem Vorteil ist.

Die Ausnehmung ist vorteilhaft ein Durchbruch oder ein Loch durch den Bauteilträger, vorteilhaft mit gleichbleibendem Durchmesser und/oder Querschnitt, also zylindrisch. Besonders vorteilhaft ist es eine rundzylindrische Form. Alternativ kann die Ausnehmung auch nur eine Vertiefung sein, beispielsweise teilkugelförmig oder kegelförmig.

Der Durchmesser der Ausnehmung im Bauteilträger kann 40% bis 95% des Durchmessers des Kontaktierungsmaterials an der Unterseite des Gehäuses aufweist, bevorzugt 60% bis 85%, besonders bevorzugt 70% bis 80%. Jedenfalls kann das Kontaktierungsmaterial die Ausnehmung deutlich überlappen, und zwar an allen Seiten.

Die Querschnittsfläche der Ausnehmung im Bauteilträger 40% bis 95% der Querschnittsfläche des Kontaktierungsmaterials an der Unterseite des Gehäuses aufweist, insbesondere 60% bis 85%, bevorzugt 70% bis 80%.

Bei der Erfindung ist das elektrisch leitfähige elastische Kontaktierungsmaterial ein Elastomer, beispielsweise als Silikonelastomer oder als thermoplastisches Elastomer (TPE). Es kann eine Härte von 30 bis 90 Shore A aufweisen, vorzugsweise 40 bis 50 oder 65 bis 70. So kann es durch eine relativ geringe Andruckkraft zusammengepresst werden und gut an dem Kontaktfeld anliegen bei gleichzeitiger Federwirkung. Dabei kann besonders vorteilhaft vorgesehen sein, dass hauptsächlich oder sogar nur das Kontaktierungsmaterial an dem Kontaktfeld bzw. an dem Bauteilträger angedrückt ist, nicht jedoch das sonstige Gehäuse bzw. die sonstige Baueinheit.

In weiterer vorteilhafter Ausgestaltung der Erfindung ist es möglich, dass der elektrisch leitfähige Kunststoff für das Sensorelement, insbesondere wenn er elastisch ist, die Oberseite des Gehäuses ein kleines Stück überragt. Dies kann um etwa 1 µm bis 1 mm oder 2 mm sein, vorteilhaft um 50 µm bis 500 µm. Der Überstand ist also sehr gering und sollte eben nur so sein, dass bei leichter Andruckkraft die sonstige Oberseite des Gehäuses knapp unter dem Bedienfeld verläuft. Vorzugsweise ist der elektrisch leitfähige Kunststoff für das Sensorelement allgemein ein Elastomer.

Es kann vorgesehen sein, dass die elektrische Kontaktierung zur elektrischen Verbindung des genannten Sensorelements an den Bauteilträger im unteren Bereich der Baueinheit denselben Kunststoff aufweist wie das Sensorelement. Eine elektrische Kontaktierung zu dem elektrisch leitfähigen Kunststoff an der Oberseite als Sensorelement kann insbesondere ebenfalls einen elektrisch leitfähigen Kunststoff aufweisen, der als teilweise oder vollständig durchgängige Schicht an der Außenseite des Gehäuses bzw. der Baueinheit aufgebracht sein kann. In einer besonders vorteilhaften Ausgestaltung der Erfindung ist es in allen drei Fällen derselbe elektrisch leitfähige Kunststoff, der also sowohl an der Oberseite als Sensorelement vorgesehen ist als auch an der Unterseite als elektrische Kontaktierung an ein Kontaktfeld auf dem Bauteilträger sowie als elektrische Verbindung zwischen den beiden Bereichen. Vorteilhaft wird er auch in einem einzigen Schritt durch einen entsprechenden Spritzvorgang aufgebracht. Die elektrische Kontaktierung an der Unterseite zum Bauteilträger hin kann relativ klein sein, insbesondere Abmessungen von 1 mm bis 5 mm in der Breite aufweisen. Die elektrische Verbindung dazwischen kann ähnlich groß sein, kann aber auch vollständig umlaufen.

Das Gehäuse ist erfindungsgemäß im montierten Zustand derart stark gegen den Bauteilträger gedrückt, dass das Kontaktierungsmaterial mindestens 5% bis 50% des Durchmessers der Ausnehmung weit in die Ausnehmung hinein gedrückt ist. Dabei liegt das Kontaktierungsmaterial zumindest teilweise an dem Leitermaterial auch in der Ausnehmung an. Dies ist unabhängig davon, welche Form die Ausnehmung aufweist.

Vor allem wenn die Ausnehmung ein zylindrischer Durchbruch oder ein zylindrisches Loch ist, kann das Kontaktierungsmaterial 3% bis 30%, vorzugsweise 5% bis 10%, des Durchmessers des Durchbruchs oder des Lochs weit an einer mit Leitermaterial beschichteten Innenwandung verlaufen bzw. sich hinein erstrecken.

An der Unterseite des Gehäuses kann in mehreren, vorteilhaft zwei, voneinander getrennten Bereichen Kontaktierungsmaterial vorgesehen sein, das auf jeweils gleiche Art und Weise an jeweils einem Kontaktfeld mit Ausnehmung darunter und somit in die Ausnehmung hinein angedrückt ist.

Der elektrisch leitfähige Kunststoff als kapazitives Sensorelement an der Oberseite läuft bei einem mehreckigen Querschnitt des Gehäuses bzw. der Baueinheit, vorzugsweise ein viereckiger bzw. rechteckiger Querschnitt, an mindestens einer Seite entlang. Vorteilhaft sind dies zwei oder drei Seiten, so dass das davon gebildete kapazitive Sensorelement größer wird bzw. empfindlicher und wirksamer. Vorteilhaft läuft es an vier Seiten um bzw. ist ganz umlaufend ausgebildet, also als eine Art Rahmen. Die Größe sollte dabei in etwa so sein, dass ein Auflegen eines Fingers an der Oberseite des Bedienfeldes gut erkannt werden kann, also beispielsweise von 5 x 5 mm bis 15 x 15 mm.

In vorteilhafter Ausgestaltung der Erfindung kann das Kontaktierungsmaterial an der Unterseite zur elektrischen Kontaktierung eine Art zumindest teilweise umlaufenden Absatz bilden, vorzugsweise ganz umlaufend. Mit diesem Absatz kann das Gehäuse gegen das Kontaktfeld oder Kontaktierungen auf dem Bauteilträger gedrückt werden als elektrischer Anschluss.

An der Unterseite des Gehäuses kann in zwei oder mehr voneinander getrennten Bereichen Kontaktierungsmaterial vorgesehen sein, das auf jeweils gleiche Art und Weise an jeweils einem Kontaktfeld mit Ausnehmung darunter angedrückt ist.

Der elektrisch leitfähige Kunststoff wird vorteilhaft an das Gehäuse angespritzt, zumindest der an der Oberseite und/oder der an der Unterseite. Hier kann ein Mehrkomponentenspritzen vorteilhaft sein, insbesondere als 2K- oder als 3K-Spritzen.

In weiterer Ausgestaltung der Erfindung ist es möglich, dass das Gehäuse an seiner Oberseite bzw. zur Oberseite hin einen Lichtleitkörper aufweist, der über dem Leuchtmittel verläuft. Das Gehäuse kann also nicht nur das Leuchtmittel ringartig umgeben, sondern auch den Lichtleitkörper, zumindest in einem unteren Bereich. Der Lichtleitkörper kann dabei auch eine Art Diffusor bilden für das Licht, um eine gleichmäßig ausgeleuchtete Symbolanzeige oder Leuchtanzeige zu schaffen. Des Weiteren kann er, insbesondere auch durch Ausgestaltung an seiner unteren Seite als Lichteintrittsseite, entsprechende Lichtsammeleigenschaften aufweisen. Er kann auch in einem Mehrkomponentenspritzvorgang, wie eingangs genannt, zusammen mit dem Gehäuse hergestellt werden und integraler Bestandteil sein.

Die Befestigungsmittel können mindestens ein nach unten abstehendes Befestigungsglied aufweisen, welches in eine entsprechend ausgebildete Ausnehmung in dem Bauteilträger eingesteckt werden kann. Vorteilhaft sind es zwei Befestigungsglieder für eine sichere und verdrehfreie Befestigung. Die Befestigungsglieder können besonders vorteilhaft unterschiedliche Querschnitte in Einsteckrichtung bzw. Längsrichtung aufweisen, so dass eine Verwechslung der Einsteckposition vermieden wird. Schließlich kann ein Befestigungsglied zum selbsthalternden Einstecken ausgebildet sein, beispielsweise durch Klemmung aufgrund größerer Querschnitte oder durch Widerhaken oder Rasthaken, so dass sonstige Befestigungen wie Kleben odgl. entfallen können.

Die Bedieneinrichtung weist einen Bauteilträger auf, auf dem mindestens eine vorbeschriebene Sensorelementeinrichtung angeordnet ist und/oder befestigt ist. Des Weiteren ist die Sensorelementeinrichtung an dem Bauteilträger auch elektrisch kontaktiert, insbesondere als Anschluss des kapazitiven Sensorelements und ggf. des Leuchtmittels. Die Bedieneinrichtung weist auch ein vorgenanntes Bedienfeld auf, an dessen Unterseite die Sensorelementeinrichtung anliegt. Durch Auflegen eines Fingers auf das Bedienfeld kann eine entsprechende Steuerung erfolgen, wie dies dem Fachmann aus dem vorgenannten Stand der Technik bekannt ist.

In besonders vorteilhafter Ausgestaltung der Erfindung ist die Bedieneinrichtung für ein Kochfeld vorgesehen, so dass das Bedienfeld eine Kochfeldplatte des Kochfeldes sein kann. Dabei können eben mehrere Sensorelementeinrichtungen auf einem Bauteilträger unter der Kochfeldplatte vorgesehen sein und verschiedene Schaltfunktionen ermöglichen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine seitliche Schnittdarstellung einer Sensorelementeinrichtung für eine erfindungsgemäße Bedieneinrichtung über einem Bauteilträger,
- Fig. 2: die Sensorelementeinrichtung aus Fig. 1 teilweise eingesteckt in den Bauteilträger,
- Fig. 3: eine Schnittdarstellung durch eine Bedieneinrichtung eines Kochfeldes mit der Sensorelementeinrichtung aus Fig. 1, die gegen den Bauteilträger aus Fig. 2 gedrückt ist,
- Fig. 4: eine Draufsicht auf die Anlage von Kontaktierungen an Kontaktfelder mit mittigen Ausnehmungen,
- Fig. 5: eine vergrößerte Schnittdarstellung durch die eingedrückte Anlage der Fig. 4 und
- Fig. 6: eine Darstellung ähnlich Fig. 5 mit leicht abgehobener Sensorelementeinrichtung.

### Detaillierte Beschreibung der Ausführungsbeispiele

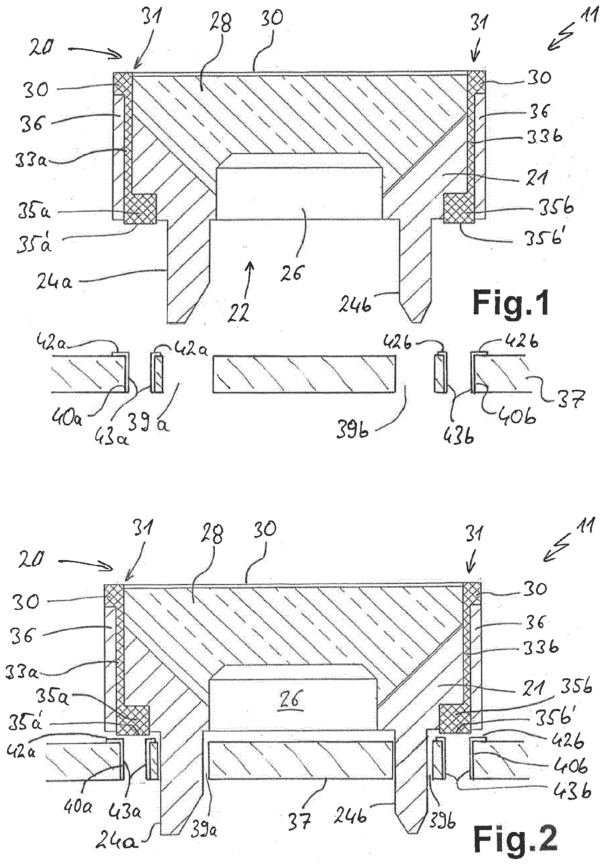

In der Fig. 1 ist im seitlichen Schnitt eine Sensorelementeinrichtung 11 für eine erfindungsgemäße Bedieneinrichtung dargestellt, die ein Gehäuses 22 mit einer Oberseite 20 aufweist. Das Gehäuse 22 weist ein Unterteil 21 auf, von dem Befestigungsstifte 24a und 24b mit unterschiedlichen Querschnitten als Befestigungsmittel abstehen, wobei das Unterteil 21 aus lichtundurchlässigem Kunststoff besteht. Ein Oberteil des Gehäuses 22 wird von einem Lichtleitkörper 28 aus lichtdurchlässigem Kunststoff gebildet. Eine Ausnehmung 26 ist sowohl im Unterteil 21 als auch im Lichtleitkörper 28 des Gehäuses 22 vorgesehen. Darin kann eine LED bzw. ein Leuchtmittel angeordnet sein.

An der oberen Außenseite des Gehäuses 22 bzw. des Lichtleitkörpers 28 ist ein umlaufender Kragen 30 angeformt. Der Kragen 30 besteht aus elastischem und elektrisch leitfähigem Kunststoff, vorzugsweise einem Elastomer, beispielsweise einem vorgenannten elektrisch leitfähigen Silikonelastomer oder elektrisch leitfähigem TPE, und ist vorteilhaft an das Gehäuse 22 bzw. den Lichtleitkörper 28 angespritzt. Der umlaufende Kragen 30 bildet auch das eingangs genannte kapazitive Sensorelement 31. Wie zu erkennen ist, steht der Kragen 30 etwas über die Oberseite 20 über, beispielsweise 50 µm bis 100 µm.

Unten an dem Kragen 30 sind links und rechts außen an das Gehäuse 22 jeweils streifenartige elektrische Verbindungskontaktierungen 33a und 33b angeformt. Sie gehen unten jeweils in eine linke und eine rechte elektrische Kontaktierung 35a und 35b aus dem vorgenannten elastischen und elektrisch leitfähigen Kontaktierungsmaterial über, vorzugsweise als Elastomer. Die Kontaktierungen 35a und 35b weisen an ihren Unterseiten Flächen 35a' und 35b' auf, die bevorzugt allgemein eben sind. Vorteilhaft sind, wie dargestellt, Kragen 30, Verbindungskontaktierung 33 und Kontaktierungen 35 aus demselben Material hergestellt, besonders vorteilhaft dem vorgenannten TPE, und können vorteilhaft einstückig hergestellt sein. Somit kann das kapazitive Sensorelement 31 unten an den Kontaktierungen 35a und 35b elektrisch kontaktiert werden, was nachfolgend noch näher erläutert wird. Dabei können die Kontaktierungen 35a und 35b etwas über die Unterseite des Unterteils 21 überstehen, beispielsweise 50 µm bis 200 µm.

Unter dem Gehäuse 22 ist eine Leiterplatte 37 als Bauteilträger vorgesehen. Die Leiterplatte 37 weist zum Einstecken der beiden Befestigungsstifte 24a und 24b Löcher 39a und 39b auf, die vorteilhaft rundgebohrt sind. Des Weiteren weist die Leiterplatte 37 daneben zwei Durchbohrungen 40a und 40b auf, die vorteilhaft ebenfalls kreisrunden Querschnitt haben und somit rundzylindrisch sind. Eine derartige Herstellung von Löchern bzw. Durchbohrungen in der Leiterplatte 37 erfolgt am leichtesten durch Bohren.

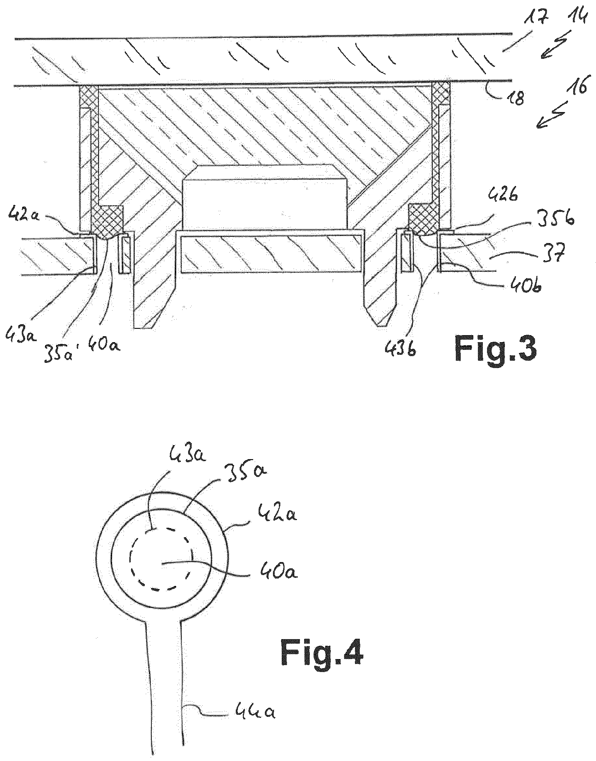

Wie zu erkennen ist, sind die Durchbohrungen 40a und 40b im Bereich von Kontaktfeldern 42a und 42b auf der Oberseite der Leiterplatte 37 vorgesehen. Diese Kontaktfelder 42a und 42b können rund bzw. kreisrund sein, alternativ auch rechteckig bzw. quadratisch oder allgemein von beliebiger Form. Davon gehen Leiterbahnen ab, die an eine Steuerung bzw. Auswertung angeschlossen sind, wie dies aus dem Stand der Technik bekannt ist und in Fig. 4 angedeutet ist. Durch das Herstellen der Durchbohrungen 40a und 40b vor dem Beschichten mit dem Leitermaterial, vorteilhaft Kupfer, ist dieses Leitermaterial nach Art einer üblichen Durchkontaktierung 43a und 43b auch entlang der Durchbohrungen 40a und 40b bis an die Unterseite vorgesehen. Somit ist es unter Umständen sogar möglich, eine elektrische Kontaktierung an die Kontaktfelder 42a und 42b und somit auch an das kapazitive Sensorelement 31 entlang der Unterseite der Leiterplatte 37 zu führen.

In der Fig. 2 ist zu ersehen, wie das Gehäuse 22 mit den Befestigungsstiften 24a und 24b in die Leiterplatte 37 bzw. deren entsprechende Löcher 39a und 39b eingesteckt ist. Die Flächen 35a' und 35b' bzw. Unterseiten der Kontaktierungen 35a und 35b befinden sich noch ein Stück oberhalb der Kontaktfelder 42a und 42b. Aus der Fig. 2 ist vor allem die Überdeckung der Flächen 35a' und 35b' mit den Kontaktfeldern 42a und 42b zu ersehen.

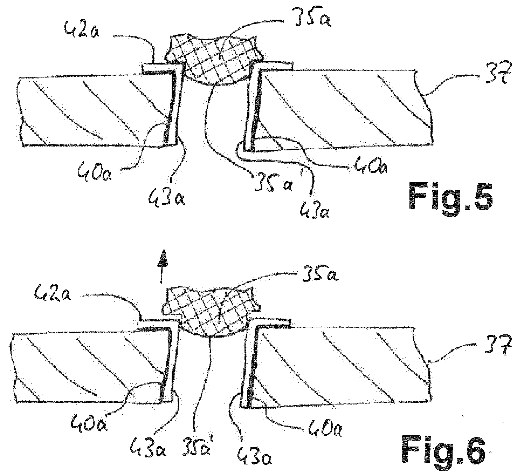

In der Fig. 3 ist eine gesamte Bedieneinrichtung 14 bzw. ein Ausschnitt aus einem Kochfeld 16 dargestellt. Die Leiterplatte 37 mit dem Gehäuse 22 darauf ist nun derart gegen eine Unterseite 18 einer Kochfeldplatte 17 als Abdeckung bzw. Bedienfeld und somit Bedienfläche angedrückt, dass das kapazitive Sensorelement 31 gut und mit seiner im Wesentlichen gesamten Oberseite an dieser Unterseite anliegt. In grundsätzlich ähnlicher Form sind die Kontaktierungen 35a und 35b mit ihren Flächen 35a' und 35b' gegen die Kontaktfelder 42a und 42b gedrückt. Somit liegen sie auf deren Oberseiten an zum Herstellen des elektrischen Kontakts. Darüber hinaus sind sie aber auch gemäß der Erfindung ein Teil in die Durchkontaktierungen 43a und 43b hineingedrückt, was aus der Fig. 5 in schematischer Vergrößerung deutlicher zu erkennen ist. Dabei kann das elastische Kunststoffmaterial der Kontaktierungen 35a und 35b mehrere 100 µm weit eingedrückt sein bei einem Durchmesser der Durchbohrungen 40a und 40b bzw. der Durchkontaktierungen 43a und 43b von 1 mm bis 2 mm. Dies bedeutet, dass über eine Tiefe von 50 µm bis 150 µm das Kontaktierungsmaterial im oberen Bereich an den Durchkontaktierungen 43a und 43b anliegt. Somit wird die Kontaktfläche von der in den Fig. 1 bis 3 horizontalen Ebene auch in die vertikale Richtung erweitert.

Dies weist den zusätzlichen Vorteil auf, wie die Fig. 6 zeigt, dass bei gealtertem Kontaktierungsmaterial, welches zwar noch eine gewisse Elastizität aufweisen kann, aber keine federnden Eigenschaften mehr hat, bei einem Abheben der Sensorelementeinrichtung 11 bzw. des Gehäuses 22 von der Leiterplatte 37 die elektrische Kontaktierung über Berühren in der vertikalen Richtung noch erhalten bleibt. Dies gilt zwar nicht mehr bei größeren bzw. stärkeren Bewegungen. Zumindest bei einem geringfügigen Abheben im Bereich von maximal 100 µm ist der elektrische Kontakt jedoch noch gegeben, nämlich in diesem vorgenannten vertikalen Bereich.

Bei Abmessungen des Gehäuses 22 mit einer Länge zwischen 5 mm und 10 mm und einer Höhe zwischen 3 mm und 7 mm kann das Erhalten der elektrischen Kontaktierung bei einem vorbeschriebenen Bewegungsweg von maximal 100 µm bereits einen signifikanten Vorteil bedeuten.

Zur Ergänzung ist in der Fig. 4 noch quasi in Draufsicht entsprechend der Fig. 3 dargestellt, wie bei runder Ausgestaltung des Kontaktfelds 42a, von dem nach unten eine Leiterbahn 44a abgeht, und runder Durchbohrung 40a und somit auch runder Durchkontaktierung 43a eine runde Kontaktierung 35a aus dem elastischen Kontaktierungsmaterial aufliegt. Die Anordnung muss nicht konzentrisch sein, insbesondere nicht die Kontaktierung 35a im Hinblick zu der Durchkontaktierung 43a bzw. der Durchbohrung 40a oder dem Kontaktfeld 42a. Es ist aber durchaus möglich. Vor allem sollten die Flächen 35a' und 35b'der Kontaktierungen 35a und 35b so auf den Kontaktfeldern 42a und 42b aufliegen, dass sie die Durchkontaktierungen 43 voll überlappen. So kann ein gutes Eindrücken des Kontaktierungsmaterials der Kontaktierungen 35 in die jeweilige Durchkontaktierung 43 erreicht werden.

## Patentansprüche

1. Bedieneinrichtung (14) für ein Elektrokochgerät (16), wobei die Bedieneinrichtung eine Sensorelementeinrichtung (11) und einen flächigen Bauteilträger (37) zur Anordnung der Sensorelementeinrichtung (11) darauf aufweist, wobei:
- die Sensorelementeinrichtung (11) weist ein Gehäuse (22) auf,
- das Gehäuse (22) weist ein kapazitives Sensorelement (31) an seinem oberen Bereich oder an seiner Oberseite (20) auf,
- da Gehäuse (22) weist mindestens eine elektrisch leitfähige Verbindung (33) von dem kapazitiven Sensorelement (31) an einen unteren Bereich oder an eine Unterseite (21) des Gehäuses auf,
- das Gehäuse (22) weist an seinem unteren Bereich oder an seiner Unterseite (21) elektrisch leitfähiges elastisches Kontaktierungsmaterial (35) als Elastomer auf,
- der flächige Bauteilträger (37) weist im Bereich des Kontaktierungsmaterials (35) am Gehäuse (22) oder unterhalb davon ein Kontaktfeld (42) auf, das als Beschichtung auf den flächigen Bauteilträger aufgebracht ist,
- das Kontaktfeld (42) besteht aus elektrisch leitfähigem Leitermaterial und weist eine elektrische Verbindung (44) an ein weiteres Bauteil auf dem Bauteilträger auf,
- der Bauteilträger (37) an dem Kontaktfeld (42) dort, wo das Kontaktierungsmaterial (35) an dem Kontaktfeld anliegt, eine Ausnehmung (40) aufweist,
- das Leitermaterial (43) in die Ausnehmung (40) hinein verläuft entsprechend der Form der Ausnehmung,
**dadurch gekennzeichnet, dass**
- das Kontaktierungsmaterial (35) über der Ausnehmung (40) liegt und ein größeres Ausmaß als die Ausnehmung aufweist,
- das elektrisch leitfähige elastische Kontaktierungsmaterial (35) über die Unterseite (21) des Gehäuses (22) übersteht zur Anlage auf dem flächigen Bauteilträger (37),
- das Gehäuse (22) im montierten Zustand derart stark gegen den Bauteilträger (37) gedrückt ist, dass das Kontaktierungsmaterial (35) mindestens 5% bis 50% des Durchmessers der Ausnehmung (40) weit in die Ausnehmung hinein gedrückt ist, wobei das Kontaktierungsmaterial (35) dabei zumindest teilweise an dem Leitermaterial (43) in der Ausnehmung (40) anliegt.

2. Bedieneinrichtung nach Anspruch 1, **dadurch gekennzeichnet, dass** die Ausnehmung (40) ein Durchbruch oder ein Loch durch den Bauteilträger (37) ist, vorzugsweise mit gleichbleibendem Durchmesser und/oder Querschnitt.

3. Bedieneinrichtung nach Anspruch 1 oder 2, **dadurch gekennzeichnet, dass** der Durchmesser der Ausnehmung (40) im Bauteilträger (37) 40% bis 95% des Durchmessers des Kontaktierungsmaterials (35) an der Unterseite (21) des Gehäuses (22) aufweist, insbesondere 60% bis 85%, bevorzugt 70% bis 80%.

4. Bedieneinrichtung nach Anspruch 1 oder 2, **dadurch gekennzeichnet, dass** die Querschnittsfläche der Ausnehmung (40) im Bauteilträger (37) 40% bis 95% der Querschnittsfläche des Kontaktierungsmaterials (35) an der Unterseite (21) des Gehäuses (22) aufweist, insbesondere 60% bis 85%, bevorzugt 70% bis 80%.

5. Bedieneinrichtung nach Anspruch 2, **dadurch gekennzeichnet, dass** das Kontaktierungsmaterial (35) 3% bis 30%, vorzugsweise 5% bis 10%, des Durchmessers der Durchbruchs oder des Lochs weit an einer mit Leitermaterial (43) beschichteten Innenwandung verläuft.

6. Bedieneinrichtung nach einem der vorhergehenden Ansprüche, **dadurch gekennzeichnet, dass** an der Unterseite (21) des Gehäuses (22) in zwei voneinander getrennten Bereichen Kontaktierungsmaterial (35) vorgesehen ist, das auf jeweils gleiche Art und Weise an einem Kontaktfeld (42) mit Ausnehmung (40) darunter angedrückt ist.

7. Bedieneinrichtung nach einem der vorhergehenden Ansprüche, **dadurch gekennzeichnet, dass** elektrisch leitfähiger Kunststoff (30) als kapazitives Sensorelement (31) die Oberseite (20) des Gehäuses (22) etwas überragt, vorzugsweise um 1 µm bis 1 mm.

8. Bedieneinrichtung nach einem der vorhergehenden Ansprüche, **dadurch gekennzeichnet, dass** elektrisch leitfähiger Kunststoff (30) als kapazitives Sensorelement (31) bei einem mehreckigen Querschnitt des Gehäuses (22) an mindestens einer Seite entlangläuft, vorzugsweise an mindestens zwei oder drei Seiten, wobei er insbesondere an vier Seiten bzw. ganz umlaufend ausgebildet ist.

9. Bedieneinrichtung nach einem der vorhergehenden Ansprüche, **dadurch gekennzeichnet, dass** elektrisch leitfähiger Kunststoff (30) als kapazitives Sensorelement (31) an das Gehäuse (22) angespritzt ist, insbesondere zusammen mit dem Kontaktierungsmaterial (35), vorzugsweise in einem Mehrkomponentenspritzvorgang.

10. Bedieneinrichtung nach einem der vorhergehenden Ansprüche, **gekennzeichnet durch** eine Abdeckung (17) bzw. Bedienblende als Bedienfläche über dem Gehäuse (22), wobei das Gehäuse (22) mit Kraftbeaufschlagung an der Unterseite (18) der Abdeckung (17) anliegt, vorzugsweise mit dem kapazitiven Sensorelement (31) an seinem oberen Bereich.

11. Bedieneinrichtung nach einem der vorhergehenden Ansprüche, **dadurch gekennzeichnet, dass** die Befestigungsmittel mindestens ein nach unten abstehendes Befestigungsglied (24) zum Einstecken in eine Ausnehmung (39) in dem Bauteilträger (37) aufweisen.

12. Elektrokochgerät (16) mit einer Bedieneinrichtung (14) nach einem der vorhergehenden Ansprüche und mit einer Abdeckung (17) bzw. Bedienblende für die Bedienfläche der Bedieneinrichtung (14), wobei die Sensorelementeinrichtung (11) an die Unterseite (18) der Abdeckung (17) bzw. Bedienblende angedrückt befestigt ist.

## Claims

1. Operating device (14) for an electric cooking appliance (16), wherein the operating device comprises a sensor element device (11) and a planar component carrier (37) for arrangement of the sensor element device (11) thereon, wherein:
- the sensor element device (11) has a housing (22),
- the housing (22) has a capacitive sensor element (31) on its upper region or on its top side (20),
- the housing (22) has at least one electrically conductive connection (33) from the capacitive sensor element (31) to a lower region or to a bottom side (21) of the housing,
- the housing (22) has on its lower region or on its bottom side (21) electrically conductive elastic contacting material (35) in the form of an elastomer,
- the planar component carrier (37) has a contact field (42) in the region of the contacting material (35) on the housing (22) or underneath thereof, which contact field is applied as a coating on the planar component carrier,
- the contact field (42) is composed of electrically conductive conductor material and has an electrical connection (44) to a further component on the component carrier,
- the component carrier (37) has a recess (40) on the contact field (42) at the location where the contacting material (35) rests on the contact field,
- the conductor material (43) passes into the recess (40), according to the shape of the recess,
**characterized in that**
- the contacting material (35) is located above the recess (40) and has a larger extent than the recess,
- the electrically conductive elastic contacting material (35) projects beyond the bottom side (21) of the housing (22) for abutment on the planar component carrier (37),
- the housing (22), in the assembled state, is pressed against the component carrier (37) strong enough that the contacting material (35) is pressed into the recess at least 5% to 50% of the diameter of the recess (40), wherein the contacting material (35) at least partially rests on the conductor material (43) in the recess (40).

2. Operating device according to claim 1, **characterized in that** the recess (40) is a perforation or a hole through the component carrier (37), preferably having a constant diameter and/or cross section.

3. Operating device according to claim 1 or 2, **characterized in that** the diameter of the recess (40) in the component carrier (37) is 40% to 95% of the diameter of the contacting material (35) on the bottom side (21) of the housing (22), in particular 60% to 85%, preferably 70% to 80%.

4. Operating device according to claim 1 or 2, **characterized in that** the cross sectional area of the recess (40) in the component carrier (37) is 40% to 95% of the cross sectional area of the contacting material (35) on the bottom side (21) of the housing (22), in particular 60% to 85%, preferably 70% to 80%.

5. Operating device according to claim 2, **characterized in that** the contacting material (35) extends 3% to 30%, preferably 5% to 10%, of the diameter of the perforation or the hole along an inner wall coated with the conductor material (43).

6. Operating device according to any of the preceding claims, **characterized in that** on the bottom side (21) of the housing (22), in two separate zones, contacting material (35) is provided which is pressed to a contact field (42) with a recess (40) below, in each case in the same manner.

7. Operating device according to any of the preceding claims, **characterized in that** electrically conductive synthetic material (30) as capacitive sensor element (31) projects somewhat beyond the top side (20) of the housing (22), preferably by 1 µm to 1 mm.

8. Operating device according to any of the preceding claims, **characterized in that**, with a polygonal cross section of the housing (22), electrically conductive synthetic material (30) as capacitive sensor element (31) extends along at least one side, preferably on at least two or three sides, wherein in particular the synthetic material is on four sides or all around the circumference.

9. Operating device according to any of the preceding claims, **characterized in that** electrically conductive synthetic material (30) as capacitive sensor element (31) is injection moulded on the housing (22), in particular together with the contacting material (35), preferably in a multi-component injection moulding procedure.

10. Operating device according to any of the preceding claims, **characterized by** a cover (17) or control panel as an operating surface above the housing (22), wherein the housing (22) rests with force application on the bottom side (18) of the cover (17), preferably with the capacitive sensor element (31) on the upper region thereof.

11. Operating device according to any of the preceding claims, **characterized in that** the fastening means include at least one fastening member (24) projecting downwards for inserting into a recess (39) in the component carrier (37).

12. Electric cooking appliance (16) having an operating device (14) according to any of the preceding claims and having a cover (17) or control panel for the operating surface of the operating device (14), wherein the sensor element device (11) is attached to the bottom side (18) of the cover (17) or control panel by pressing against.

## Revendications

1. Dispositif de commande (14) destiné à un appareil de cuisson électrique (16), le dispositif de commande comportant un dispositif à élément de détection (11) et un support de composants (37) sensiblement bidimensionnel destiné à disposer le dispositif à élément de détection (11) sur celui-ci,
- le dispositif à élément de détection (11) comportant un boîtier (22),
- le boîtier (22) comportant un élément de détection capacitif (31) sur sa région supérieure ou sur son côté supérieur (20),
- le boîtier (22) comportant au moins une liaison électriquement conductrice (33) allant de l'élément de détection capacitif (31) à une région inférieure ou à un côté inférieur (21) du boîtier,
- le boîtier (22) comportant un matériau de contact élastique (35) électriquement conducteur sous forme d'élastomère au niveau de sa région inférieure ou de son côté inférieur (21),
- le support de composants (37) sensiblement bidimensionnel comportant dans la région du matériau de contact (35) sur le boîtier (22) ou au-dessous de celui-ci une zone de contact (42) qui est appliquée en tant que revêtement sur le support de composants sensiblement bidimensionnel,
- la zone de contact (42) comprenant un matériau conducteur électriquement conducteur et comportant une liaison électrique (44) avec un autre composant sur le support de composants,
- le support de composants (37) comportant un évidement (40) sur la zone de contact (42) où le matériau de contact (35) est en appui sur la zone de contact,
- le matériau conducteur (43) s'étendant jusque dans l'évidement (40) en suivant la forme de l'évidement,
**caractérisé en ce que**
- le matériau de contact (35) est situé par-dessus l'évidement (40) et est plus grand que l'évidement,
- le matériau de contact élastique (35) électriquement conducteur fait saillie du côté inférieur (21) du boîtier (22) pour venir en appui sur le support de composants (37) sensiblement bidimensionnel,
- le boîtier (22) est pressé à l'état monté si fortement contre le support de composants (37) que le matériau de contact (35) est enfoncé dans l'évidement sur au moins 5 % à 50 % du diamètre de l'évidement (40), le matériau de contact (35) venant en appui au moins partiellement contre le matériau conducteur (43) dans l'évidement (40).

2. Dispositif de commande selon la revendication 1, **caractérisé en ce que** l'évidement (40) est un passage ou un trou ménagé dans le support de composants (37) et ayant de préférence un diamètre et/ou une section constante.

3. Dispositif de commande selon la revendication 1 ou 2, **caractérisé en ce que** le diamètre de l'évidement (40) ménagé dans le support de composants (37) est de 40 % à 95 % du diamètre du matériau de contact (35) sur le côté inférieur (21) du boîtier (22), en particulier 60 % à 85 %, de préférence 70 % à 80 %.

4. Dispositif de commande selon la revendication 1 ou 2, **caractérisé en ce que** l'aire en coupe transversale de l'évidement (40) ménagé dans le support de composants (37) est de 40 % à 95 % de l'aire en coupe transversale du matériau de contact (35) sur le côté inférieur (21) du boîtier (22), en particulier 60 % à 85 %, de préférence 70 % à 80 %.

5. Dispositif de commande selon la revendication 2, **caractérisé en ce que** le matériau de contact (35) s'étend sur 3 % à 30 %, de préférence 5 % à 10 %, du diamètre du passage ou du trou sur une paroi intérieure revêtue de matériau conducteur (43).

6. Dispositif de commande selon l'une des revendications précédentes, **caractérisé en ce que** du matériau de contact (35) est prévu dans deux régions séparées l'une de l'autre sur le côté inférieur (21) du boîtier (22) et est pressé à chaque fois de la même manière sur une zone de contact (42) pourvue d'un évidement (40) au-dessous.

7. Dispositif de commande selon l'une des revendications précédentes, **caractérisé en ce qu'**une matière synthétique (30) électriquement conductrice fait saillie légèrement du côté supérieur (20) du boîtier (22), de préférence sur 1 µm à 1 mm, en tant qu'élément de détection capacitif (31).

8. Dispositif de commande selon l'une des revendications précédentes, **caractérisé en ce que**, dans le cas où le boîtier (22) a une section transversale polygonale, une matière synthétique (30) électriquement conductrice est formée en tant qu'élément de détection capacitif (31) le long d'au moins un côté, de préférence le long d'au moins deux ou trois côtés, en particulier sur quatre côtés ou sur toute la périphérie.

9. Dispositif de commande selon l'une des revendications précédentes, **caractérisé en ce que** de la matière synthétique (30) électriquement conductrice est pulvérisée sur le boîtier (22) en tant qu'élément de détection capacitif (31), en particulier avec le matériau de contact (35), de préférence dans un procédé de pulvérisation multi-composants.

10. Dispositif de commande selon l'une des revendications précédentes, **caractérisé par** un couvercle (17) ou un panneau de commande faisant office de surface de commande sur le boîtier (22), le boîtier (22) venant en appui en force sur le côté inférieur (18) du couvercle (17), de préférence avec l'élément de détection capacitif (31) dans sa région supérieure.

11. Dispositif de commande selon l'une des revendications précédentes, **caractérisé en ce que** les moyens de fixation comportent au moins un organe de fixation (24) saillant vers le bas et destiné à être inséré dans un évidement (39) ménagé dans le support de composants (37).

12. Appareil de cuisson électrique (16) comprenant un dispositif de commande (14) selon l'une des revendications précédentes et un couvercle (17) ou panneau de commande destiné à la surface de commande du dispositif de commande (14), le dispositif à élément de détection (11) étant fixé par pression sur le côté inférieur (18) du couvercle (17) ou du panneau de commande.
